# EUROPEAN PATENT APPLICATION

(11) **EP 3 046 133 A1**
(43) Date of publication of application: **20.07.2016**
(21) Application number: 15150996.5
(22) Date of filing: 13.01.2015
(51) Int. Cl.: H01J 37/14, H01J 37/153

(54) **Multipole magnetic lens for manipulating a beam of charged particles**

(71) Applicant: FEI COMPANY, Hillsboro, Oregon 97124-5793 (US)
(72) Inventor: Shanel, Ondrej, 5602 BS Eindhoven (NL); Henstra, Alexander, 3544 PW Utrecht (NL)
(74) Representative: Bakker, Hendrik

(57) **Abstract**

A multipole magnetic lens for manipulating a beam of charged particles traveling along an optical axis, the lens comprising:
- Magnetic field generating means, for generating a magnetic field;
- A magnetic yoke, comprising a plurality of radial yoke portions disposed about said optical axis so as to guide and concentrate said magnetic field toward an interaction region proximal to the optical axis,

wherein:
- Said yoke has a composite structure, comprising an outer primary portion and an inner secondary portion;
- Said secondary portion is mounted as a monolithic insert within said primary portion so as to be disposed around said interaction region;
- Said secondary portion comprises a plurality of yoke stubs that are arranged around said optical axis and that are rigidly interconnected by a connecting structure such that:
▪ Said yoke stubs align up and match with said radial yoke portions;
▪ Said connecting structure acts as a magnetic constriction, configured such that said magnetic field undergoes saturation therein, thereby causing magnetic flux to exit the yoke stubs and form a multipole field in said interaction region.

## Description

The invention relates to a multipole magnetic lens for manipulating a beam of charged particles traveling along an optical axis, the lens comprising:
- Magnetic field generating means, for generating a magnetic field;
- A magnetic yoke, comprising a plurality of radial yoke portions disposed about said optical axis so as to guide and concentrate said magnetic field toward an interaction region proximal to the optical axis.

The invention also relates to a method of focusing a beam of charged particles using such a multipole magnetic lens.

The invention additionally relates to a method of manufacturing such a multipole magnetic lens.

The invention further relates to a charged particle microscope comprising:
- A charged-particle source, for producing an irradiating beam of charged particles that propagate along an optical axis;
- A specimen holder, for holding a specimen to be irradiated;
- A particle-optical column, for directing said beam onto said specimen;
- A detector, for detecting a flux of output radiation emanating from the specimen in response to said irradiation,
wherein said particle-optical column comprises at least one multipole magnetic lens as set forth in the opening paragraph above.

Multipole magnetic lenses as set forth in the opening paragraph above are well known, and are employed *inter alia* to correct imaging aberrations (such as spherical and/or chromatic aberration, for example) and/or as energy filters in devices such as Charged Particle Microscopes (CPMs), where they commonly take the form of quadrupole, sextupole, octupole or dodecapole lenses, for example. In the context of the current invention, the term "multipole" should be generically interpreted as referring to a lens with n poles (n > 2), where n is a natural number that is typically even, but not necessarily so. Conventionally, such a lens comprises a plurality n of pole pieces (yoke portions) that are (radially) arranged so as to converge upon (point toward) a centrally disposed, intervening "air gap", which comprises said interaction region; although conventionally referred to as an "air gap", such a gap may, in fact, be vacuous, or may be (partially) filled with non-magnetic material, for example. This air gap is traversed by magnetic field lines from the pole pieces when said magnetic field generating means (e.g. an electric coil) are invoked (excited); for example, in the case of a quadrupole lens, a "saddle-shaped" magnetic field can be produced in said gap.

For extensive information on magnetic multipole lenses - particularly as applied in charged particle microscopy - reference is made to the following book: Handbook of Charged Particle Optics, Second Edition, edited by Jon Orloff, CRC Press (Florida), 2009, ISBN-13: 978-1-4200-4554-3, particularly Chapter 4 et seq*.:*
https://books.google.nl/books?id=y0FF19lud5YC&pq=PA129&dg=multipole+particle+lens+ chapter+4&hl=en&sa=X&ei=PtOrVJjbGMvsO-epgIAD&ved=0CDIQ6AEwAQ#v=onepage&q=multipole%20particle%20lens%20chapter% 204&f=false

As already alluded to above, a particularly important use of multipole magnetic lenses is in charged particle microscopy, which is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" Focused Ion Beam (FIB), allowing supportive activities such as ion-beam milling or Ion-Beam-Induced Deposition (IBID), for example. More specifically:
- In a SEM, irradiation of a specimen by a scanning electron beam precipitates/stimulates emanation of "auxiliary" radiation from the specimen, in the form of secondary electrons, backscattered electrons, X-rays and photoluminescence (infrared, visible and/or ultraviolet photons), for example; one or more components of this emanating radiation is/are then detected and used for image accumulation purposes, spectroscopy (such as EDX), etc.
- In a TEM, the electron beam used to irradiate the specimen is chosen to be of a high-enough energy to penetrate the specimen (which, to this end, will generally be thinner than in the case of a SEM specimen); the flux of transmitted electrons emanating from the specimen can then be used to create an image, spectrum, etc. When such a TEM is operated in scanning mode (thus becoming a STEM), an image can be accumulated during a scanning motion of the irradiating electron beam.

More information on some of the topics elucidated here can, for example, be gleaned from the following Wikipedia links:
- http://en.wikipedia.org/wiki/Electron microscope
- http://en.wikipedia.org/wiki/Scanning electron microscope
- http://en.wikipedia.org/wiki/Transmission electron microscopy
- http://en.wikipedia.org/wiki/Scanning transmission electron microscopy

As an alternative to the use of electrons as irradiating beam, charged particle microscopy can also be performed using other species of charged particle. In this respect, the phrase "charged particle" should be broadly interpreted as encompassing electrons, positive ions (e.g. Ga or He ions), negative ions, protons and positrons, for instance. As regards ion-based microscopy, some further information can, for example, be gleaned from sources such as the following:
- http://en.wikipedia.org/wiki/Scanning Helium Ion Microscope
- W.H. Escovitz, T.R. Fox and R. Levi-Setti, Scanning Transmission Ion Microscope with a Field Ion Source, Proc. Nat. Acad. Sci. USA 72(5), pp. 1826-1828 (1975).
- http://www.innovationmagazine.com/innovation/volumes/v7n1/coverstory3.shtml

In all cases, a CPM will comprise at least the following components:
- A radiation source, such as a Schottky electron source or ion gun.
- An illuminator, which serves to manipulate a "raw" radiation beam from the source and perform upon it certain operations such as focusing, aberration mitigation, cropping (with an aperture), filtering, etc. It will generally comprise one or more (charged-particle) lenses, and may comprise other types of (particle-)optical component also. If desired, the illuminator can be provided with a deflector system that can be invoked to cause its output beam to perform a scanning motion across the specimen being investigated.
- A specimen holder, on which a specimen under investigation can be held and positioned (e.g. tilted, rotated). If desired, this holder can be moved so as to effect scanning motion of the beam w.r.t. the specimen. In general, such a specimen holder will be connected to a positioning system such as a mechanical stage.
- A detector system (for detecting radiation emanating from an irradiated specimen), which can take many different forms, depending on the radiation being detected. Examples include photomultipliers (including solid state photomultipliers, SSPMs), photodiodes, CMOS detectors, CCD detectors, photovoltaic cells, etc., which may, for example, be used in conjunction with a scintillator film, for instance. In the specific case of X-ray detection, use is typically made of a so-called Silicon Drift Detector (SDD), or a Silicon Lithium (Si(Li)) detector, for example.

In the case of a transmission-type CPM (such as a (S)TEM, for example), the apparatus/tool will also comprise:
- An imaging system, which essentially takes charged particles that are transmitted through a specimen (plane) and directs (focuses) them onto analysis apparatus, such as a detection/imaging device, spectroscopic apparatus (such as an EELS module), etc. As with the illuminator referred to above, the imaging system may also perform other functions, such as aberration mitigation, cropping, filtering, etc., and it will generally comprise one or more charged-particle lenses and/or other types of particle-optical components.
One or more multipole magnetic lenses (of similar or different types) may be employed in said illuminator and/or said imaging system.

In what follows, the invention may - by way of example - sometimes be set forth in the specific context of electron microscopy. However, such simplification is intended solely for clarity/illustrative purposes, and should not be interpreted as limiting

As is known to the skilled artisan, the pole pieces (yoke portions) in a multipole magnetic lens must be carefully aligned relative to one another and the associated (particle-)optical axis if one is to accurately produce a magnetic field with the desired shape (geometry / pattern / configuration). So as to facilitate proper alignment and performance, such pole pieces typically need to be manufactured to tight mechanical tolerances - often of the order of 10 µm or less - as a result of which these pole pieces tend to be relatively expensive parts. An extra complication is that the magnetic material comprised in the pole pieces should ideally have a relatively low hysteresis; to achieve this, said material is typically annealed, which tends to limit subsequent machinability of the pole pieces (e.g. with lathes and milling machines). As a result of such factors, manufacture of magnetic multipole lenses tends to be a relatively expensive and wasteful procedure, and it typically involves complicated and tedious manual alignment of multiple pole pieces that have been painstakingly manufactured to high tolerances - and which will not yield optimal performance if said alignment is not of a sufficiently high accuracy.

It is an object of the invention to address these issues. In particular, it is an object of the invention to provide a multipole magnetic lens design that allows more accurate and easier alignment of component parts (yoke portions). Moreover, it is an object of the invention that such a design should lend itself to easier machining of critical parts, leading to lowered manufacturing costs.

These and other objects are achieved in a multipole magnetic lens as set forth in the opening paragraph above, which is characterized according to the invention in that:
- Said yoke has a composite structure, comprising an outer primary portion and an inner secondary portion;
- Said secondary portion is mounted as a monolithic insert within said primary portion so as to be disposed around said interaction region;
- Said secondary portion comprises a plurality of yoke stubs that are arranged around said optical axis and that are rigidly interconnected by a connecting structure such that:
   ▪ Said yoke stubs align up and match with said radial yoke portions;
   ▪ Said connecting structure acts as a magnetic constriction, configured such that said magnetic field undergoes saturation therein, thereby causing magnetic flux to exit the yoke stubs and form a multipole field in said interaction region.

The invention is based on a number of synergistic insights, as follows:
- Use of an air gap between converging pole pieces is the traditional way of forcing magnetic flux to break out of a yoke and into an interaction region where it is to produce a given particle-optical effect (such as aberration mitigation). However, the existence of such an air gap *de facto* requires the existence of *separate* pole pieces - with the attendant difficulty of accurately aligning them relative to one another (and the associated optical axis).
- The present invention adopts a radically different mechanism to this traditional set-up. Instead of working with separate pole pieces, an inner (secondary) portion of the yoke is provided (around the interaction region) with a connecting structure that connects a terminal part (a "stub" or nose) of each pole piece into a collective, rigid arrangement. This connecting structure becomes magnetically saturated when it is permeated by a magnetic field from the employed magnetic field generating means, thus becoming a magnetic constriction: as a result, it does not act as a magnetic "short circuit" between the participating yoke stubs, and therefore does not prevent desired escape of flux into the interaction region (where it is exploited to produce the desired beam manipulating effect on a charged particle beam passing through said interaction region).
- Because the new design connects the component yoke stubs into a single, rigid collective using the inventive connecting structure, a *monolithic* design becomes possible - thus obviating the need to mutually align several separate pole pieces post manufacture.
- To facilitate manufacture, the yoke is given a composite structure, comprising:
   ▪ A relatively large primary portion, which can be manufactured to relatively low tolerances and typically comprises the bulk of the yoke, situated distal from the (relatively critical) interaction region. This primary portion comprises the desired number of cooperating radial yoke portions (e.g. 4, 6, or 8, for instance), which may, if desired, be mounted on an outer connecting body, such as a peripheral yoke frame.
   ▪ A relatively small, monolithic secondary portion, which can be manufactured to relatively high tolerances, situated vicinal to the (relatively critical) interaction region. This secondary portion can be fully manufactured *ex situ,* and then mounted as a single insert within (a seating structure provided in) the primary portion.
These primary and secondary portions can typically (though not necessarily) comprise different materials.

It should be noted that the deliberate incorporation of magnetically saturated material into a lens design would traditionally tend to be met with some trepidation by the skilled artisan, *inter alia* for the reasons (i)-(iii) hereunder; in this respect, the current invention can thus be regarded as being somewhat counterintuitive:
(i) Deliberately saturating a portion of the yoke (as in the present invention) causes a phenomenon whereby, when using the lens at a high excitation, the volume of saturated material will be larger than when using the lens at a low excitation. One can think of such a change as being equivalent to a dimensional change in the air gap, with an attendant change in lens strength as a function of excitation. In a conventional lens, increasing charged-particle energy by a factor of four will predictably require the lens excitation/current to be increased by a factor of two, in order to produce the same manipulating effect by the lens; however, in a lens using saturated material (as in the present invention), unpredictable deviation from this simple functional dependence might be expected, due to the above-mentioned volume change effect.
(ii) Magnetic lens design is typically performed with the aid of simulation-based Finite Element Modeling (FEM). In modern FEM programs, for each of the elements (corresponding to voxels) in a given simulation, a given permeability value is calculated in successive iterations. As more voxels become increasingly saturated, the attendant number of iterations increases sharply. Consequently, lens designers tend to prefer lens designs that are relatively poor in saturated material.
(iii) The presence of saturated material in a lens design implies a reduced maximum attainable multipole strength for that lens (as compared to a lens without saturated material). This is because the presence of saturated material in the connecting structure partially/proportionally lowers the saturation excitation (expressed in "Ampere turns") for the yoke as a whole, of which the connecting structure is a (relatively small, but non-negligible) constituent part.
Designers of magnetic charged-particle lenses have thus traditionally had several reasons to keep the amount of magnetically saturated material in a lens design as low as possible, e.g. limited to the edges defining the interaction region. Such a tendency points strongly away from the present invention.

In an embodiment of the current invention, said magnetic field generating means are selected from the group comprising electric coils, permanent magnets, and combinations hereof.

Lenses based on permanent magnets are well known, and have the advantage that they need consume no electrical power in use. Lenses employing electric coils tend to be used more often, as they allow an adjustment in field strength (and thus particle-optical behavior) *via* adjustment of the electrical current sent through the coil(s) in question. A combination of both these approaches allows a lens in which most of the magnetic field can be generated by the employed permanent magnets, while a variation of this field (to higher or lower levels) can be achieved by appropriate excitation of the accompanying electrical coil(s).

In another embodiment, said primary and secondary portions comprise different magnetic materials.

In such an embodiment, only a relatively small part of the yoke (said secondary portion) need be comprised of high-quality magnetic material, machined to a high accuracy and annealed to the highest magnetic standards, while other parts of the yoke (said primary portion) can comprise materials of lower grade, with relaxed tolerances, magnetic quality and/or annealing standards - resulting in a composite yoke that is cheaper and easier to manufacture.

In yet another embodiment, at least the secondary portion of the yoke comprises magnetic material selected from the group comprising ferromagnetic material, ferrite, and combinations hereof.

Examples of (low-hysteresis) ferromagnetic materials include (in pure form or as alloys) Fe, Co and Ni, and these may be supplemented by traces of, for example, Cu, Mo, Si, Va, and/or Cr.

Ferrites (comprising iron oxides) also lend themselves to such use: see, in this regard (for example):
http://en.wikipedia.org/wiki/Ferrite %28magnet%29

For more information about magnetic material in general, reference is made to the following German-language publication: R. Boll, *Weichmagnetische Werkstoffe,* Vacuumschmelze GmbH & Co. KG, ISBN 3-80090154604.

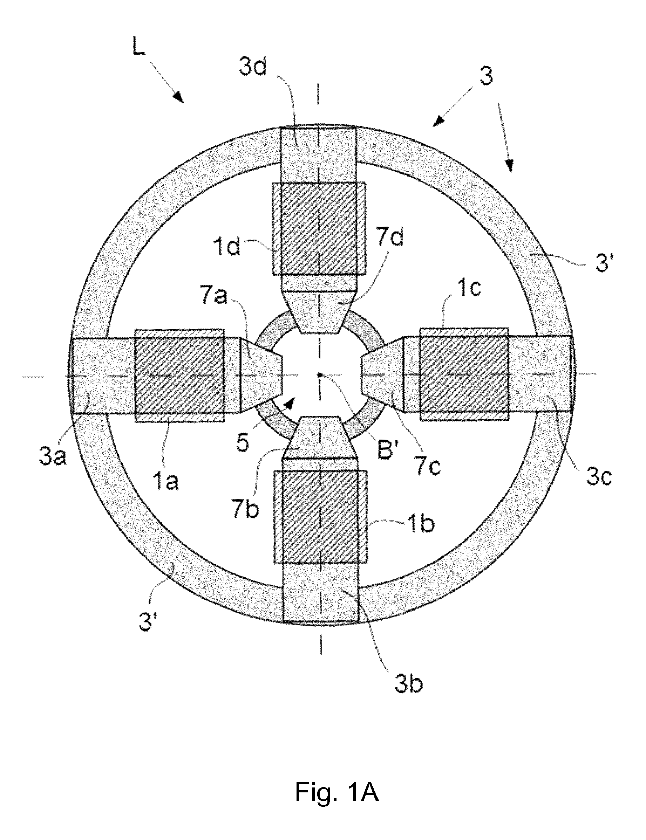

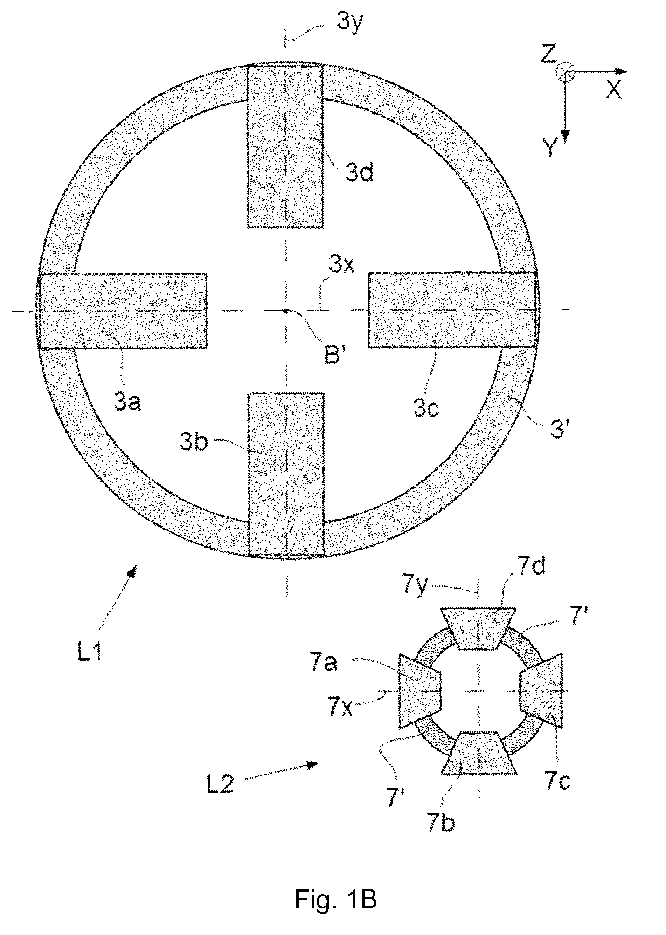

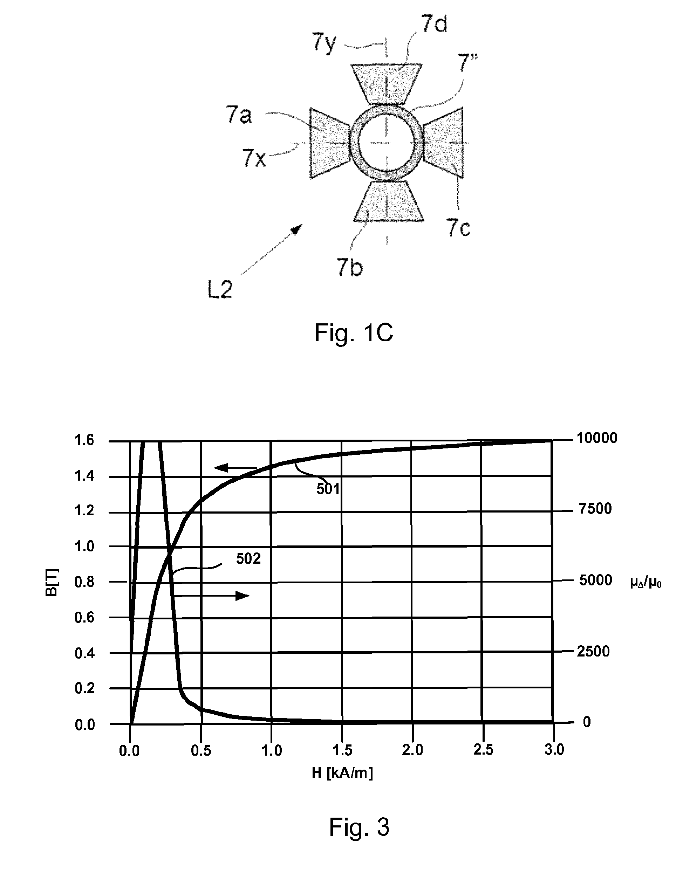

In principle, the connecting structure between the yoke stubs of the current invention could take many different forms, e.g. it might be embodied as a polygonal assembly of straight rods that interconnect adjacent stubs, or it might be a disc-like member (with a central aperture) on a major surface of which the stubs are arranged and affixed. In a particular embodiment, the connecting structure is substantially ring-shaped (somewhat like a donut), e.g. as illustrated in Figure 1, for instance. Such an embodiment has the advantage of having a relatively constant/uniform transverse cross-sectional shape, which, in turn, has a beneficial effect in tending to decrease (unwanted) alteration of the generated field geometry/profile as a function of excitation. For example:
- A quadrupole lens (n = 4) will - in addition to producing the intended quadrupole field - also tend to create a (parasitic) 12-pole field, 20-pole field etc. (generally it will produce m-pole fields, with m = {*n, 3n, 5n, 7n,...*})*.*
- In many situations, it is good design practice to make at least the 12-pole (in general 3n-pole) field zero, by choosing a proper yoke geometry.
- The inventors have observed that, if the inventive connecting structure is non-uniform, then a situation can arise whereby the 12-pole field will only be zero (suppressed) for a specific excitation, and will manifest itself (re-emerge) at other excitations. This can be especially undesirable if the so-called "fill factor" F (= charged-particle beam diameter divided by multipole inner-bore diameter [interaction region diameter]) has a value close to one. It is noted in this regard that:
   ▪ For aberration correctors, F typically has a value much less than one;
   ▪ For energy filters, F may have a larger value, e.g. In a range ca. 0.1-0.5.
- Summarizing: in general, a uniform connecting structure (cross-section) can be advantageous.
Regardless of its general geometrical shape, the connecting structure will preferably have a relatively small transverse cross-sectional area (e.g. with a diameter of the order of ca. 1-2 mm), so as to facilitate its role as a magnetic constriction; this is because a thin structure will advantageously tend to magnetically saturate (as a function of increasing applied field) well before the material of the (larger) yoke stubs starts to saturate. If desired, one could embody such a ring-shaped structure as a hollow torus with a relatively large cross-sectional diameter but with a relatively thin wall; the cumulative amount of material in the cross-sectional area is then still small enough to be relatively easily saturated, whereas the relatively large-diameter hollow cross-section gives good structural stability (e.g. as regards torsional / shear stiffness).

In a particular embodiment, the occurrence of magnetic saturation as specified above (in the connecting structure) leads to a reduction in incremental permeability µ_{Δ} (in the direction of the multipole field) to at most 10% of a maximum attainable incremental permeability µΔₘₐₓ, and preferably to at most 1% of µ_{Δmax}.

By defining saturation in terms of incremental permeability µ_{Δ} = δB/δH (where H is magnetic field strength), and by stipulating µ_{Δsat} < µ_{Δmax}/10 - and preferably µ_{Δ,sat} < µ_{Δmax}/100 - at a magnetic field above the magnetic field value at which µ_{Δmax} occurs, an objective value can be ascribed to saturation, instead of the often-used definition of "asymptotic value".

The skilled artisan will understand that, according to the present invention, there are various possible ways in which the inner secondary yoke portion can be manufactured. One such way, for example, is to pre-manufacture a suitable hollow mold (e.g. in two co-operating halves) corresponding to the desired configuration of yoke stubs and the connecting structure, and then fill this mold with molten metal; when the cast/poured metal has cooled and solidified, it can be removed from the mold and subjected to various desired post-treatments, such as trimming, polishing, annealing, etc. Another possible way would be to construct the whole inner secondary yoke portion additively using a 3D printing technique. Alternatively, one could manufacture it subtractively, by starting with a relatively large metallic block and machining it into the desired shape (e.g. using milling, Electrical Discharge Machining (EDM), etching, etc.). Yet another approach would be to manufacture the component parts of the inner secondary portion (i.e. yoke stubs and (component segments of) the connecting structure) as separate entities, mount them to some sort of holder (e.g. modeling clay/resin/cement), arrange them into the desired configuration/geometry/alignment, and then fuse them together (e.g. thermally, or using a UV-activated adhesive, for instance).

The skilled artisan will also understand that, according to the present invention, there are many suitable ways in which the inner secondary portion of the yoke may be mounted within the co-operating outer secondary portion. One could, for example, use an adhesive to attach one to the other. Alternatively, one could some sort of soldering or welding, such as a spot weld or seam weld, for example. Yet another possibility would to be employ some form of mechanical fixation using, for example, screws/bolts, clamping collars, etc. In another approach, one could, for example, use springs (or other resilient members) to bias the radial yoke portions inwardly against the co-operating yoke stubs, thereby producing a sprung abutment / pressure clamp; an advantage of such an approach is that it would allow slight radial expansion/contraction of the radial yoke portions in response to thermal fluctuations. The skilled artisan will also understand that the opposing, co-operating faces of the radial yoke portions and the associated yoke stubs are advantageously polished flat/smooth, and will preferably stay is tight abutment against one another, so as to minimize the size of any (parasitic) air gap between them, which would (disadvantageously) act as a source of flux leakage.

It should be remembered that magnetic materials often change dimensions when magnetized, due to an effect known as magnetostriction; conversely, stress/strain on a magnetic material can affect its magnetic properties. In view of this, the skilled artisan will understand that it is generally desirable to avoid undue pressure/strain in the secondary yoke portion (insert) as it is mounted within the primary yoke portion.

It should be noted that a beneficial effect of the present invention is that the power dissipation of lenses according to the invention tends to be more constant than that of prior-art lenses - since, in inventive lenses, part of the (coil) power is needed just to attain the desired localized saturation (in the connecting structure). This implies that a "zero load" must always be used to saturate the yoke, with the rest of the power being used to cause the desired multipole magnetic field.

As a final general remark, it should be noted that the term "monolithic" as applied to the secondary yoke portion (insert) is intended to imply that the insert in its most basic pre-insertion form - e.g. without a particular mounting structure that might be used to place / align / affix it within the primary yoke portion - is a one-piece component. This does not necessarily mean that a structure from which it is manufactured cannot be composite: for example, one could envisage machining (part of) the secondary insert from a workpiece with a laminated structure, or one might coat the insert with a thin film after manufacture, etc. The term "monolithic" is principally intended to distinguish from the prior-art situation in which *multiple* separate, individual, independent pole pieces have to be manually aligned with respect to one another post manufacture.

The invention will now be elucidated with the aid of Embodiments and the accompanying schematic drawings, in which:
Figures 1A, 1B and 1C schematically show an embodiment of a multipole magnetic lens according to the present invention.
Figure 2 shows an embodiment of a charged particle microscope (in this case, a (S)TEM) in which a multipole magnetic lens according to the present invention is employed.
Figure 3 schematically shows the relation between B(H) and µᵣ(H) (magnetic field and permeability as a function of magnetic field strength).
In the Figures, where relevant, corresponding features may be indicated using identical reference symbols.

### Embodiment 1

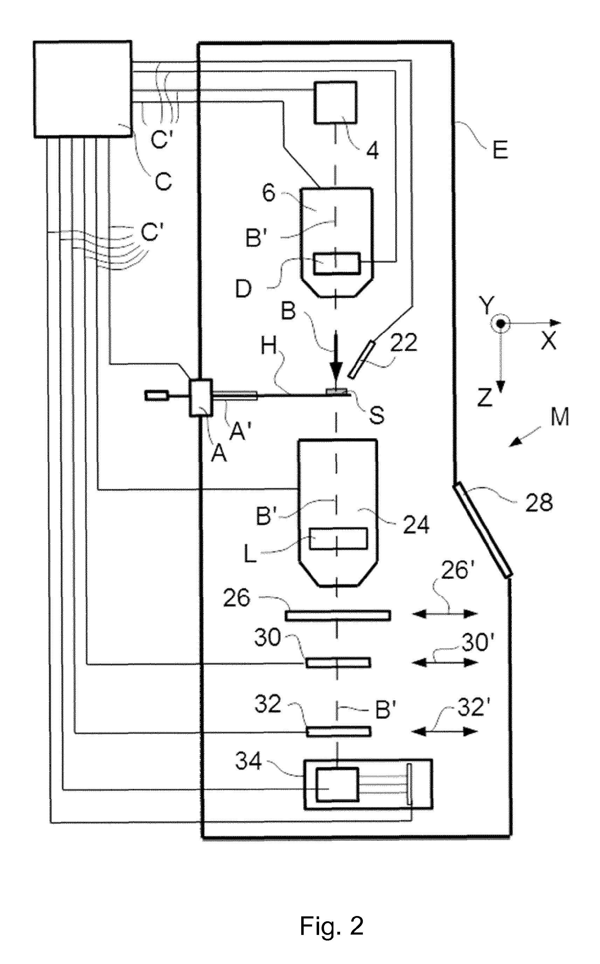

Figures 1A, 1B and 1C schematically show (in plan view) various aspects of a particular embodiment of a multipole magnetic lens L according to the present invention. In the illustrated example, the lens L is a quadrupole lens (n = 4), with the following aspects:
1a-1d: Magnetic field generating means, for generating a magnetic field. In the present situation, each of items 1 a, 1 b, 1 c, 1 d is an electric coil.
3: A magnetic yoke, which comprises an outer primary portion L1 and a co-operating inner secondary portion L2 (see Figure 1B, in which items 1 a-1 d have been omitted, for conciseness). Outer primary portion L1 comprises a plurality of radial yoke portions 3a-3d disposed about an optical axis B' (see Figure 2) so as to guide and concentrate the magnetic field from coils 1a-1d toward an interaction region 5 proximal to the optical axis B'. In the current situation, each of the radial yoke portions 3a, 3b, 3c, 3d is, for example, a substantially cylindrical bar of magnetic material around which the (respective) associated coil 1 a, 1 b, 1 c, 1 d is wound/placed. The radial yoke portions 3a-3d are attached to an outer yoke ring / holding frame 3', which provides structural integrity and an outer magnetic circuit for magnetic flux generated by the coils 1a-1d.
5: The aforementioned interaction region. A charged-particle beam B travelling along axis B' (see Figure 2) will pass through this region 5, where it can be manipulated by the magnetic field produced by (excited) lens L.
7a-7d: Yoke stubs ("noses"), corresponding in number (four) and location (quadrant configuration) to the associated radial yoke portions 3a-3d. These yoke stubs 7a-7d are rigidly interconnected by a connecting structure 7', thereby forming the (monolithic) inner secondary portion L2 of yoke 3, in such a manner that, when L2 is inserted within L1, each of the yoke stubs 7a, 7b, 7c, 7d aligns up and matches with (respective) corresponding radial yoke portion 3a, 3b, 3c, 3d; in practice, this means that, when properly inserted, (longitudinal/cylindrical/conical) axes 7x, 7y of portion L2 will be accurately aligned along respective (longitudinal/cylindrical) axes 3x, 3y of portion L1. So as to prevent it acting as a magnetic "short circuit" between the yoke stubs 7a-7d, the connecting structure 7' is configured *(inter alia* by making it relatively thin) in such a way that the aforementioned magnetic field undergoes (early) saturation therein; in this way, it acts as a magnetic constriction, whence magnetic flux is forced to exit the yoke stubs 7a-7d and form a manipulating multipole field in said interaction region 5.
As set forth above, the outer primary portion L1 of the yoke 3 can (if so desired) be manufactured/machined/finished to relatively low tolerances, whereas the inner secondary portion L2 will typically be made to higher tolerances.

For good order, Figure 1C shows an alternative rendition of inner secondary portion L2, in which the connecting structure 7' lies wholly within the yoke stubs 7a-7d. This is just one of many possible alternatives.

### Embodiment 2

Figure 2 is a highly schematic depiction of an embodiment of a CPM according to the current invention; more specifically, it shows an embodiment of a transmission-type microscope M, which, in this case, is a TEM/STEM (though, in the context of the current invention, it could just as validly be an ion-based microscope, or a SEM, for example). In the Figure, within a vacuum enclosure E, an electron source 4 (such as a Schottky emitter, for example) produces a beam (B) of electrons that traverse an electron-optical illuminator 6, serving to direct/focus them onto a chosen part of a specimen S (which may, for example, be (locally) thinned/planarized). This illuminator 6 has an electron-optical axis B', and will generally comprise a variety of electrostatic / magnetic lenses, (scan) deflector(s) D, correctors (such as stigmators), etc.; typically, it can also comprise a condenser system (in fact, the whole of item 6 is sometimes referred to as "a condenser system").

The specimen S is held on a specimen holder H. As here illustrated, part of this holder H (inside enclosure E) is mounted in a cradle A' that can be positioned/moved in multiple degrees of freedom by a positioning device (stage) A; for example, the cradle A' may be displaced (inter alia) in the X, Y and Z directions (see the depicted Cartesian coordinate system), and may be rotated about a longitudinal axis parallel to X (roll, alpha tilt, Rx). Such movement allows, for example:
- Different parts of the specimen S to be irradiated / imaged / inspected by the electron beam traveling along axis B';
- Selected parts of the specimen S to be machined by an optionally present (non-depicted) focused ion beam;
- The specimen S to be tilted, e.g. during acquisition of a tilt series / sinogram in tomographic investigations;
- Scanning motion to be performed as an alternative to beam scanning (using deflector(s) D).

The (focused) electron beam B traveling along axis B' will interact with the specimen S in such a manner as to cause various types of "stimulated" radiation to emanate from the specimen S, including (for example) secondary electrons, backscattered electrons, X-rays and optical radiation (cathodoluminescence). If desired, one or more of these radiation types can be detected with the aid of detector 22, which might be a combined scintillator/photomultiplier or EDX (Energy-Dispersive X-Ray Spectroscopy) module, for instance; in such a case, an image/spectrum could be constructed using basically the same principle as in a SEM. However, alternatively or supplementally, one can study electrons that traverse (pass through) the specimen S, emerge (emanate) from it and continue to propagate (substantially, though generally with some deflection/scattering) along axis B'. Such a transmitted electron flux enters an imaging system (combined objective/projection lens) 24, which will generally comprise a variety of electrostatic / magnetic lenses, deflectors, correctors (such as stigmators), etc. In normal (non-scanning) TEM mode, this imaging system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of) the specimen S will be formed by imaging system 24 on screen 26, and this may be viewed through viewing port 28 located in a suitable part of a wall of enclosure E. The retraction mechanism for screen 26 may, for example, be mechanical and/or electrical in nature, and is not depicted here.

As an alternative to viewing an image on screen 26, one can instead make use of the fact that the depth of focus of the electron flux emerging from imaging system 24 is generally quite large (e.g. of the order of 1 meter). Consequently, various types of detector / analysis apparatus can be used downstream of screen 26, such as:
- TEM camera (detector) 30. At camera 30, the electron flux can form a static image (or diffractogram) that can be processed by controller C and displayed on a display device (not depicted), such as a flat panel display, for example. When not required, camera 30 can be retracted/withdrawn (as schematically indicated by arrows 30') so as to get it out of the way of axis B'.
- STEM recorder (detector) 32. An output from recorder 32 can be recorded as a function of (X,Y) scanning position of the beam B on the specimen S, and an image can be constructed that is a "map" of output from recorder 32 as a function of X,Y. Recorder 32 can comprise a single pixel with a diameter of e.g. 20 mm, as opposed to the matrix of pixels characteristically present in camera 30. Moreover, recorder 32 will generally have a much higher acquisition rate (e.g. 106 points per second) than camera 30 (e.g. 102 images per second). Once again, when not required, recorder 32 can be retracted/withdrawn (as schematically indicated by arrows 32') so as to get it out of the way of axis B' (although such retraction would not be a necessity in the case of a donut-shaped annular dark field recorder 32, for example; in such a recorder, a central hole would allow beam passage when the recorder was not in use).
- Spectroscopic apparatus (detector) 34, which could be an EELS module, for example (EELS = Electron Energy-Loss Spectroscopy).
It should be noted that the order/location of items 30, 32 and 34 is not strict, and many possible variations are conceivable. For example, spectroscopic apparatus 34 can also be integrated into the imaging system 24.

Note that the controller (computer processor) C is connected to various illustrated components *via* control lines (buses) C'. This controller C can provide a variety of functions, such as synchronizing actions, providing setpoints, processing signals, performing calculations, and displaying messages/information on a display device (not depicted). Needless to say, the (schematically depicted) controller C may be (partially) inside or outside the enclosure E, and may have a unitary or composite structure, as desired. The skilled artisan will understand that the interior of the enclosure E does not have to be kept at a strict vacuum; for example, in a so-called "Environmental TEM/STEM", a background atmosphere of a given gas is deliberately introduced/maintained within the enclosure E. The skilled artisan will also understand that, in practice, it may be advantageous to confine the volume of enclosure E so that, where possible, it essentially hugs the axis B', taking the form of a small tube (e.g. of the order of 1 cm in diameter) through which the employed electron beam passes, but widening out to accommodate structures such as the source 4, specimen holder H, screen 26, camera 30, recorder 32, spectroscopic apparatus 34, etc.

In the specific context of the current invention, one or more innovative multipole magnetic lenses as hereabove described (e.g. of a type as set forth in Embodiment 1) can be employed in the imaging system 24 and/or illuminator 6 of the microscope M; as here depicted, one such lens L is schematically shown in the imaging system 24. When a plurality of such lenses L is present, it should be noted that (according to choice) they may be mutually similar or dissimilar as regards design parameters such as number of poles, size, shape, magnetic material, etc. Also, not all of them need necessarily be of a type as set forth in the present invention: if desired, one could, for example, elect to combine (less critical) conventional multipole magnetic lens designs with at least one (more critical) multipole magnetic lens design according to the current invention.

### Embodiment 3

Figure 3 schematically shows a B-H curve of a ferromagnetic material and the incremental permeability µ_{Δ} = δB/δH.

B, the magnetic field strength in Tesla, is the result of H, expressed in A/m. The relationship between the two is B = µH = µ₀ µᵣ H (µ₀ = permeability of vacuum/air; µᵣ = relative permeability). The curve shown is exemplary for pure (99.98%) Fe, also known as magnet iron. As seen in this curve, the material saturates at a field strength of approximately 1.5 T, and, as known to the skilled artisan, a well-annealed piece of pure iron has a maximum µᵣ of ca. 40000. For completely saturated material, the field B still increases, but the derivative δB/δH then equals µ₀, identical to air/vacuum. The derivative δB/δH is also known as the incremental permeability µ_{Δ}.

For practical reasons, "saturated" can be defined here as the field strength B for which µ_{Δ} equals µ_{Δmax} / 10, more preferably µ_{Δmax} / 100 (see above).

## Claims

1. A multipole magnetic lens for manipulating a beam of charged particles traveling along an optical axis, the lens comprising:
- Magnetic field generating means, for generating a magnetic field;
- A magnetic yoke, comprising a plurality of radial yoke portions disposed about said optical axis so as to guide and concentrate said magnetic field toward an interaction region proximal to the optical axis,
**characterized in that**:
- Said yoke has a composite structure, comprising an outer primary portion and an inner secondary portion;
- Said secondary portion is mounted as a monolithic insert within said primary portion so as to be disposed around said interaction region;
- Said secondary portion comprises a plurality of yoke stubs that are arranged around said optical axis and that are rigidly interconnected by a connecting structure such that:
▪ Said yoke stubs align up and match with said radial yoke portions;
▪ Said connecting structure acts as a magnetic constriction, configured such that said magnetic field undergoes saturation therein, thereby causing magnetic flux to exit the yoke stubs and form a multipole field in said interaction region.

2. A multipole magnetic lens according to claim 1, wherein said magnetic field generating means are selected from the group comprising electric coils, permanent magnets, and combinations thereof.

3. A multipole magnetic lens according to claim 1 or 2, wherein said primary and secondary portions comprise different magnetic materials.

4. A multipole magnetic lens according to any of claims 1-3, wherein said secondary portion comprises magnetic material selected from the group comprising ferromagnetic material, ferrite, and combinations hereof.

5. A magnetic lens according to any of claims 1-4, wherein said connecting structure is substantially ring-shaped.

6. A method of manipulating a beam of charged particles traveling along an optical axis, using a multipole magnetic lens comprising:
- Magnetic field generating means, for generating a magnetic field;
- A magnetic yoke, comprising a plurality of radial yoke portions disposed about said optical axis so as to guide and concentrate said magnetic field toward an interaction region proximal to the optical axis,
**characterized in that** the method comprises the following steps:
- Providing said yoke as a composite structure, comprising an outer primary portion and an inner secondary portion;
- Providing said secondary portion as a monolithic insert mounted within said primary portion so as to be disposed around said interaction region and comprising a plurality of yoke stubs that are arranged around said optical axis and that are rigidly interconnected by a connecting structure such that:
▪ Said yoke stubs align up and match with said radial yoke portions;
▪ Said connecting structure acts as a magnetic constriction;
- Invoking said magnetic field generating means to produce a saturated magnetic field in said connecting structure, thereby causing magnetic flux to exit the yoke stubs and form a multipole field in said interaction region;
- Using said multipole field to manipulate said beam of charged particles.

7. A method of manufacturing a multipole magnetic lens for manipulating a beam of charged particles traveling along an optical axis, which lens comprises:
- Magnetic field generating means, for generating a magnetic field;
- A magnetic yoke, comprising a plurality of radial yoke portions disposed about said optical axis so as to guide and concentrate said magnetic field toward an interaction region proximal to the optical axis,
**characterized in that** the method comprises the following steps:
- Manufacturing a primary portion of said yoke, comprising said radial yoke portions;
- Manufacturing a secondary portion of said yoke as a monolithic component comprising a plurality of yoke stubs that are arranged around a central axis and that are rigidly interconnected by a connecting structure such that:
▪ Said yoke stubs positionally match with said radial yoke portions;
▪ Said connecting structure acts as a magnetic constriction;
- Aligning and mounting said secondary portion as an insert within said primary portion, so that said secondary portion is disposed around said interaction region,
whereby, during manufacture, at least part of said secondary portion is machined to higher precision than said primary portion.

8. A charged-particle microscope comprising:
- A charged-particle source, for producing an irradiating beam of charged particles that propagate along an optical axis;
- A specimen holder, for holding a specimen to be irradiated;
- A particle-optical column, for directing said beam onto said specimen;
- A detector, for detecting a flux of output radiation emanating from the specimen in response to said irradiation,
wherein said particle-optical column comprises at least one multipole magnetic lens as claimed in any of claims 1-5.
